# EUROPEAN PATENT APPLICATION

(11) **EP 2 950 107 A1**
(43) Date of publication of application: **02.12.2015**
(21) Application number: 14001838.3
(22) Date of filing: 27.05.2014
(51) Int. Cl.: G01R 15/04, H01B 17/56, H01H 33/662

(54) **Voltage sensor for high and medium voltage use, and a method of making the same**

(71) Applicant: ABB Technology AG, 8050 Zürich (CH)
(72) Inventor: Javora, Radek, 624 00 Brno (CZ)
(74) Representative: Schmidt, Karl Michael

(57) **Abstract**

The invention relates to a voltage sensor for high and medium voltage use, wherein a voltage divider is arranged in a housing with external creepage distance enlarging ribs.

In order to implement structures for creepage path enlargement to a sensor housing in a very effective and easy way, the invention is, that the voltage divider, is arranged in a housing or in housing modules (7) which is or are covered at least partly by at least one shrinking tube (8) of insulating material in that way, that the shrinking creepage enlarging structures are implemented at least at outer surface of the shrinking tube.

## Description

The invention relates to a voltage sensor for high and medium voltage use, and method of making the same, according to the preamble of claim 1 and 7, 8, 9, 10 .

Present voltage sensors are using impedance divider cast in some insulation material (epoxy or polyurethane) in order to withstand voltage stresses on MV or HV lines. This solution is expensive and requires investments into the complex mold for casting, especially when the requirement of creepage distance is of the importance and ribs on sensor body are required to achieve given creepage distance.

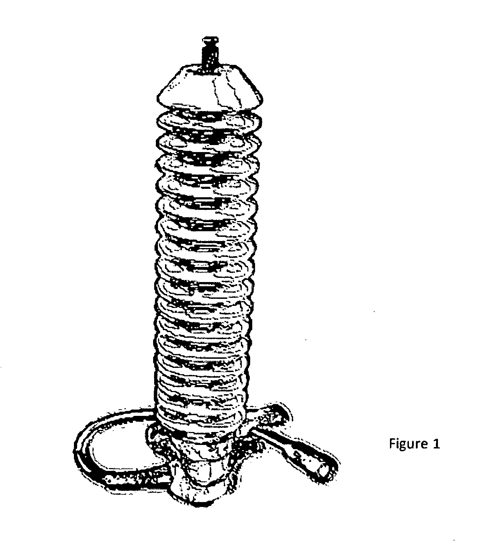

So present voltage sensors, known in the state of the art, are using impedance divider cast in some insulation material (epoxy or polyurethane) in order to withstand voltage stresses on MV or HV lines. This solution is expensive and requires investments into the complex mold for casting, especially when the requirement of creepage distance is of the importance and ribs on sensor body are required to achieve given creepage distance, see Fig.1.

So it is the object of the invention, to implement structures for creepage distance enlargement to a sensor housing in a very effective and easy way.

According to this, the invention is, that the voltage divider, is arranged in a housing or in housing modules which is or are covered at least partly by at least one shrinking tube of insulating material in that way, that the shrinking creepage distance enlarging structures are implemented at least at the outer surface of the shrinking tube.

So the basical function of the invention is, to use standard shrinking tube with sheds, which is shrinked arround a voltage divider module. This solution should bring significant cost saving in mold investments and reduction on sensor costs as well as significant reduction on manufacturing time of such solution.

Idea of this proposal is to reduce manufacturing time and effort and decrease production costs and investments needed for production. This will be done by using standard shrinking tube with sheds, which is shrinked arround a voltage divider module. This solution should bring significant cost saving in mold investments and reduction on sensor costs as well as significant reduction on manufacturing time of such solution.

A further embodiment is, that the shrinking tube is placed on the housing of the voltage divider near the distal ends of the housing, at least partly over an output cable of the voltage sensor. On advantageous embodiment of this is to cover the definite transition area between the housing and the the output cable, in order to implement at that place a creepage distance enlargement.

In a further advantageous embodiment, the voltage sensor is located within or surrounded by shielding electrodes, which are arranged inside or outside the voltage divider housing.

In a further advantageous embodiment, the voltage divider part is cast in simple shape and the insulation is done by insulating material, e.g. epoxy, polyurethane or similar.

According to this, the insulating shrinking tube can be provided as a cold shrink tube, by the use of insulating cold shrinking material.

Alternatively but also advantageous is, that the insulating shrinking tube can be provided as a warm shrink tube, by the use of insulating warm shrinking material.

So the same effect of implementing creepage distance enlargement can be placed on a sensors housing or cable in both cases in a very simple way of manufacture.

By that, the use of voltage sensor with the features or at least one of the claims 1 to 6 is given, that means that the voltage sensor is provided for indoor use.

But the same advantages occur by the use of voltage sensor with the features or at least with one of the claims 1 to 6, by that the voltage sensor is provided for outdoor use.

Consequently follows out of the invention, according to their constructive easy implementation of local creepage distance enlargement element structures, a method for producing voltage sensors can be realized easy. So the invention according to a method of manufacture is, that a preferably tubelike solid housing in which the voltage divider of the sensor is placed in, or an output cable of the voltage divider is covered by a flexible tube of insulating cold shrink material with implemented ribs structures in that way, that the diameter or resulting diameter of the aforesaid housing or the aforesaid cable is bigger than the inner diameter of the unextended flexible tube, and that the flexible tube will be extended in its diameter by means, in order to position it over the housing or the cable, and that these extending means will be removed, when the flexible tube is positioned over the housing or the cable, so that the flexible tube shrinks close on the suface of the housing or the cable.

An alternative method for manufacture is, that a preferably tubelike solid housing in which the voltage divider of the sensor is placed in, or an output cable of the voltage divider are covered by a flexible tube of insulating warm shrink material with implemented ribs structures it that way, that the diameter or the resulting diameter of the aforesaid housing or the aforesaid cable is bigger than the inner diameter of the unshrinked flexible tube, and that the flexible tube will be positioned over the housing or the cable, and that the flexible tube shrinks under heat treatment close on the surface of the housing or the cable.

State of the art is shown in Figure 1.

The invenion is shown in the drawings.
Figure 2a- 2c:
Figure 3:

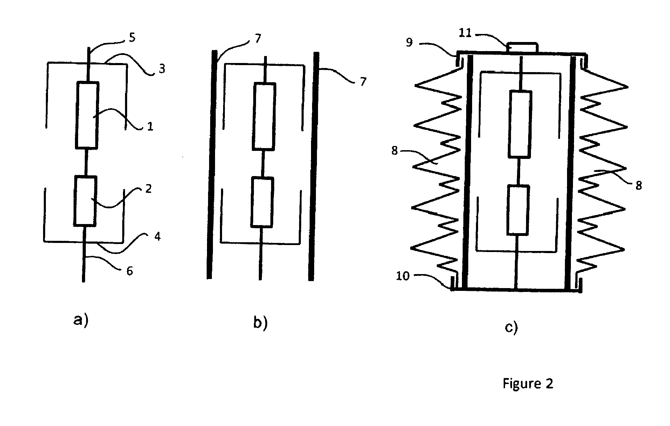

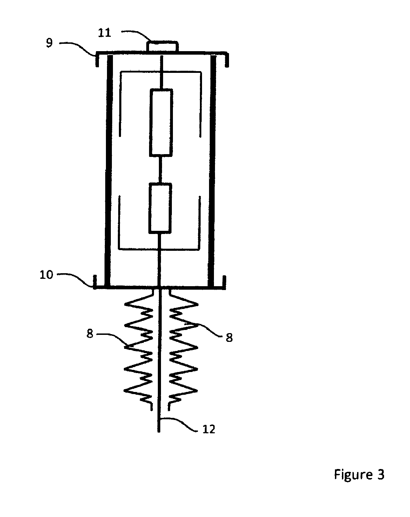

As shown in figure 2a, the design of standard voltage divider consists of high voltage impedance 1 and low voltage impedance 2. Depending on electrical design and electric field distribution, such voltage divider may also require high voltage electrode 3 and/or low voltage electrode 4. Such divider is usually cast in some insulation material as shown in figure 1 as state of the art.

Said voltage divider could be of capacitive or resistive type, or combination of both. New design of voltage sensor is not considering such casting process which will form the final shape of voltage sensor. Instead, it is proposed that voltage divider internal parts shown in figure 2a are cast in a simple insulating tube 7 or other shape of insulating material and then the shrinking tube, forming the ribs/insulator sheds 8, is applied on top. The shrinking tube may be applied using hot or cold shrinking tube technology. In order to cover the ends of shrinking tube, upper 9 and lower 10 cup could be used if needed.

Depending of final electric field distribution inside of the sensor, the upper 9 and lower 10 cups, if made of electrically conductive material, could replace the high voltage electrode 3 and/or low voltage electrode 4.

Other possibility to increase the creepage distance is not to use the shrinking tube 8 on simple body, but apply the shrinking tube with ribs on the output cable 12 instead. In this case the lower cup 10 should not be connected to the ground potential.

### Numbering

- 1: High voltage impedance
- 2: Low voltage impedance
- 3: High voltage electrode
- 4: Low voltage electrode
- 5: Cable
- 6: Cable
- 7: Insulating tube
- 8: Ribs/insulator sheds
- 9: Upper cup
- 10: Lower cup
- 11: Primary terminal to which the voltage to be measured is connected/applied
- 12: Output cable

## Claims

1. Voltage sensor for high and medium voltage use, wherein a voltage divider is arranged in a housing with external creepage distance enlarging ribs,
**characterized in that,**
the voltage divider, is arranged in a housing or in housing modules which is or are covered at least partly by at least one shrinking tube of insulating material **in that** way, that the shrinking creepage distance enlarging structures are implemented at least at outer surface of the shrinking tube.

2. Voltage sensor according to claim 1,
**characterized in that**
the shrinking tube is placed on the housing of the voltage divider near the distal ends of the housing, at least partly over an output cable of the voltage sensor.

3. Voltage sensor according to claim 1 or 2,
**characterized in that**
the voltage sensor is located within or surrounded by shielding electrodes, which are arranged inside or outside the voltage divider housing.

4. Voltage sensor according to claim 1, 2 or 3,
**characterized in that**
the voltage divider part is cast in simple shape and the insulation is done by insulating material, e.g. epoxy, polyurethane or similar.

5. Voltage sensor according to at least one of the aforesaid claims 1 to 4,
**characterized in that,**
the insulating shrinking tube is provided as a cold shrink tube, by the use of insulating cold shrinking material.

6. Voltage sensor according to at least one of the aforesaid claims 1 to 4,
**characterized in that,**
the insulating shrinking tube is provided as a warm shrink tube, by the use of insulating warm shrinking material.

7. Use of voltage sensor with the features or at least one of the claims 1 to 6, that the voltage sensor is provided for indoor use.

8. Use of voltage sensor with the features or at least one of the claims 1 to 6, that the voltage sensor is provided for outdoor use.

9. Method for producing voltage sensors, according to an embodiment of at least one of the claims 1 and 3 to 6, for the use of claim 7 or 8,
**characterized in that**
that a preferably tubelike solid housing in which the voltage divider of the sensor is placed in, or an output cable of the voltage divider is covered by a flexible tube of insulating cold shrink material with implemented ribs structures it that way, that the diameter or resulting diameter of the aforesaid housing or the aforesaid cable is bigger than the inner diameter of the unextended flexible tube, and that the flexible tube will be extended in its diameter by means, in order to position it over the housing or the cable, and that these extending means will be removed, when the flexible tube is positioned over the housing or the cable, so that the flexible tube shrinks close on the surface of the housing or the cable.

10. Method for producing voltage sensors, according to an embodiment of at least one of the claims 2 and 3 to 6, for the use of claim 7 or 8,
**characterized in that**
that a preferably tubelike solid housing in which the voltage divider of the sensor is placed in, or an output cable of the voltage divider is covered by a flexible tube of insulating warm shrink material with implemented ribs structures it that way, that the diameter or resulting diameter of the aforesaid housing or the aforesaid cable is bigger than the inner diameter of the unshrinked flexible tube, and that the flexible tube will be positioned over the housing or the cable, and that the flexible tube shrinks under heat treatment close on the surface of the housing or the cable.
